(19) Europäisches Patentamt
European Patent Office
Office européen des brevets

(11) **EP 0 763 886 B1**

(12) **EUROPEAN PATENT SPECIFICATION**

(45) Date of publication and mention
of the grant of the patent:
**21.11.2001 Bulletin 2001/47**

(51) Int Cl.[7]: **H03F 3/191**

(86) International application number:
**PCT/JP95/00880**

(21) Application number: **95917516.7**

(22) Date of filing: **09.05.1995**

(87) International publication number:
**WO 95/31036 (16.11.1995 Gazette 1995/49)**

(54) **TUNED AMPLIFIER**

ABGESTIMMTER VERSTÄRKER.

AMPLIFICATEUR ACCORDE

(84) Designated Contracting States:
**DE FR GB**

(30) Priority: **10.05.1994 JP 11971494**
**13.06.1994 JP 15310194**
**27.09.1994 JP 25603894**

(43) Date of publication of application:
**19.03.1997 Bulletin 1997/12**

(73) Proprietor: **Ikeda, Takeshi**
**Ota-Ku Tokyo 143 (JP)**

(72) Inventors:
• **IKEDA, Takeshi Asahi San-no Manshon 213**
**Tokyo 143 (JP)**

• **OHE, Tadataka**
**Saitama 330 (JP)**

(74) Representative: **Warren, Keith Stanley et al**
**BARON & WARREN**
**18 South End**
**Kensington**
**London W8 5BU (GB)**

(56) References cited:
**JP-B- 45 000 530** **JP-B- 48 034 056**

• **PATENT ABSTRACTS OF JAPAN vol. 11, no. 145 (E-505), 12 May 1987 & JP 61 281708 A (MATSUSHITA ELECTRIC IND. CO. LTD.), 12 December 1986,**

## Description

The present invention relates to a tuned amplifier which is easily configured in an integrated circuit, more specifically to a tuned amplifier in which the tuned frequency and the maximum attenuation can be adjusted to a desired level without interaction.

Various circuits using active elements and reactive elements known as tuned amplifiers are proposed and have been used practically.

Disadvantages of conventional tuned amplifiers include interaction between the tuned frequency and the maximum attenuation. That is, adjustment of the tuned frequency accompanies change in the maximum attenuation. Also, adjustment of the maximum attenuation accompanies change in the tuned frequency.

Additionally, it is difficult to configure the tuned amplifier capable of adjusting the tuned frequency and the maximum attenuation in an integrated circuit.

It is therefore an object of the present invention to overcome the above mentioned disadvantages of the conventional tuned amplifier.

According to one aspect, the invention consists in a tuned amplifier comprising:-

a first phase shift circuit comprising conversion means to convert an AC input signal applied through an input impedance into non-inverted and inverted AC signals and means comprising a first reactance element and a first resistor for combining the two AC signals converted by the conversion means of the first phase shift circuit to produce a first phase shifted AC output signal,
a second phase shift circuit comprising conversion means to convert the first phase shifted AC signal into non-inverted and inverted AC signals and means comprising a second reactance element and a second resistor for combining the two AC signals converted by the conversion means of the second phase shift circuit to produce a second phase shifted AC output signal which is phase shifted in the same direction as the first phase shifted AC output signal,
an inverter circuit for inverting the phase of the second phase shifted AC output signal, and
a feedback circuit connected between the output of the inverter circuit and the input of the first phase shift circuit and having a feedback impedance.

According to another aspect, the invention consists in a tuned amplifier comprising:-

a first phase shift circuit comprising conversion means to convert an input AC signal applied through an input impedance into non-inverted and inverted AC signals and means for combining the two converted AC signals by way of a first reactance element and a first resistor to produce a first phase shifted AC output signal,
a second phase shift circuit comprising conversion means to convert the first phase shifted AC output signal into non-inverted and inverted AC signals and means for combining the two AC signals converted by the conversion means of the second phase shift circuit by way of a second reactance element and a second resistor to produce a second phase shifted AC output signal which is phase shifted in the opposite direction to that of said first phase shifted AC output signal, and
a feedback circuit for feeding the second phase shifted AC output signal back to the input of the first phase shift circuit by way of a feedback impedance.

The invention will now be described by way of example with reference to the accompanying drawings, wherein:-

FIG.1 is a circuit schematic of a first embodiment of the tuned amplifier according to the present invention.
FIG.2 is a circuit schematic of the tuned amplifier according to the present invention represented by transfer function K.
FIG.3 is an equivalent circuit of the phase shift circuit in the tuned amplifier as shown in FIG.1.
FIG.4 is a circuit schematic showing the phase shift condition of the circuit in FIG.3.
FIG.5 is a characteristic curve representing the relationship between the maximum attenuation and the ratio in between the input resistance and the feedback resistance in the circuit as shown in FIG. 1.
FIG.6 is a circuit schematic of a second embodiment of the tuned amplifier according to the present invention.
FIG.7 is an equivalent circuit of the phase shift circuit in the tuned amplifier as shown in FIG.6.
FIG.8 is a circuit schematic showing the phase shift condition of the circuit in FIG.7.
FIG.9 is a circuit schematic of a third embodiment of the tuned amplifier according to the present invention. .
FIG.10 is a circuit schematic of a fourth embodiment of the tuned amplifier according to the present invention.
FIG.11 is a circuit schematic of a fifth embodiment of the tuned amplifier according to the present invention.
FIG.12 is a circuit schematic of a sixth embodiment of the tuned amplifier according to the present invention.
FIG.13 is a circuit schematic of an alternative embodiment of the tuned amplifier according to the present invention.

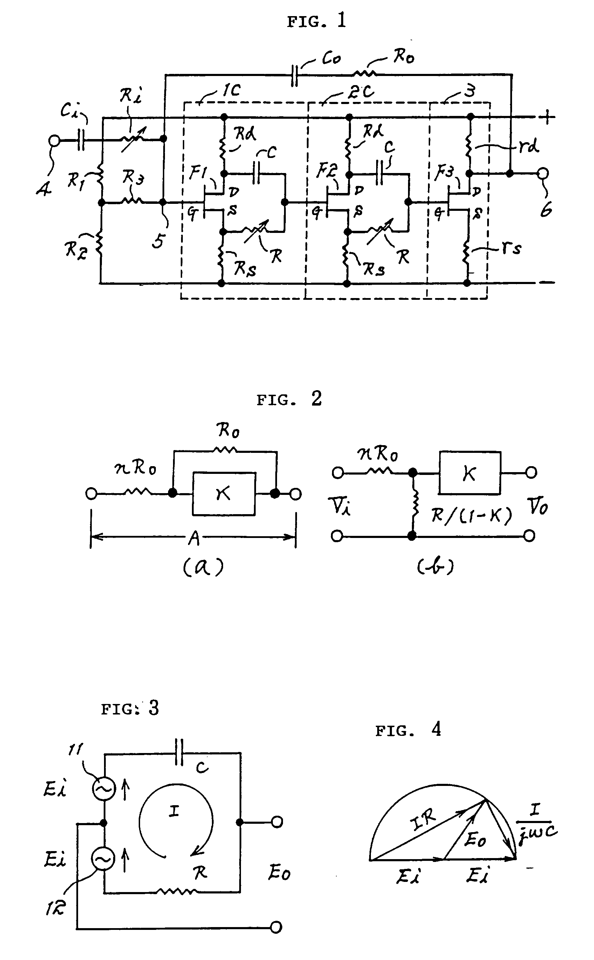

The tuned amplifier according to a first embodiment of the present invention comprises a cascade connection of a first phase shift circuit 1C, a second phase shift circuit 2C, and a phase inverter circuit 3 as illustrated in FIG.1. Further included in the tuned amplifier is a resistance Ri(=nRo) connected between an input terminal 4 and a summing point 5 acting as an input impedance, and a series circuit or resistance Ro and a DC-blocking capacitor Co connected between an output terminal 6 of the phase inverter circuit 3 and the summing point 5 as a feedback impedance.

The two phase shift circuits 1C and 2C are substantially identical to each other and comprise FETs (F1, F2) each having gate electrode G, drain electrode D and source electrode S, a resistor Rd connected between the drain electrode D and a positive voltage source, a resistor Rs connected between the source electrode S and a negative voltage source, a capacitor C as a reactance element connected to the drain electrode D, and a variable resistor R connected to the sources electrode S. A common junction of the capacitor C and the variable resistor R defines an output terminal. Note that both the resistors Rd and Rs connected respectively to the drain and source electrodes have essentially identical resistance.

The phase inverter circuit 3 comprises a FET (F3) having gate electrode G, drain electrode D and source electrode S, a resistor rd connected between the drain electrode D and the positive voltage source, and a resistor rs connected between the source electrode S and the negative voltage source. The resistance of the drain side resistor rd is chosen larger than that of the source sides resistor rs (rd>rs) so as to provide an amplification factor larger than 1 (unity).

The gate electrode G of the FET (F1) in the first phase shift circuit 1C defines a summing point 5 to which an input terminal 4 is connected by way of an adjustable input resistor Ri and a DC blocking capacitor Ci and also an output terminal 6 of the phase inverter circuit 3 is connected by way of a feedback resistor Ro and a DC blocking capacitor Co. Additionally, connected to the gate electrode G of the FET (F1) by way of a resistor R3 is a bias voltage which is a power supply voltage divided by series resistors R1, R2.

The output from the first phase shift circuit 1C is supplied to the gate electrode G of the FET (F2) which is an element constituting the second phase shift circuit 2C. On the other hand, the output from the second phase shift circuit 2C is supplied to the gate electrode of the FET (F3) in the phase inverter circuit 3. The drain electrode D of the FET (F3) is connected to the output terminal 6 and also to the summing point 5 by way of the feedback resistor Ro and the DC blocking capacitor Co.

Now, the operation of the tuned amplifier as configured above will be described hereunder.

If the circuit including such phase shift circuits 1C, 2C is represented by a circuit having a transfer function K, the entire system can be illustrated as shown in FIG. 2 (a). The circuit in FIG. 2(a) can be converted further into FIG. 2(b) by applying the Miller's principle. The transfer function A of the overall system can be given by the following expression (1):

$$A = \frac{Vo}{V1} = \frac{k}{n\,(1-k) + 1} \qquad (1)$$

When an AC voltage is applied to the gate electrode G of the FET (F1, F2) in each of the phase shift circuits 1C, 2C, an inverted AC voltage appears on the drain electrode D while a non-inverted AC voltage on the source electrode S. Such phase shift circuits 1C, 2C can be represented by an equivalent circuit as shown in FIG. 3 which is a closed loop including a signal source 11 generating an AC signal having the same polarity as the input AC signal Ei, a signal source 12 generating an AC signal having the opposite (inverted) polarity to the input AC signal Ei, a capacitor C and a resistor R.

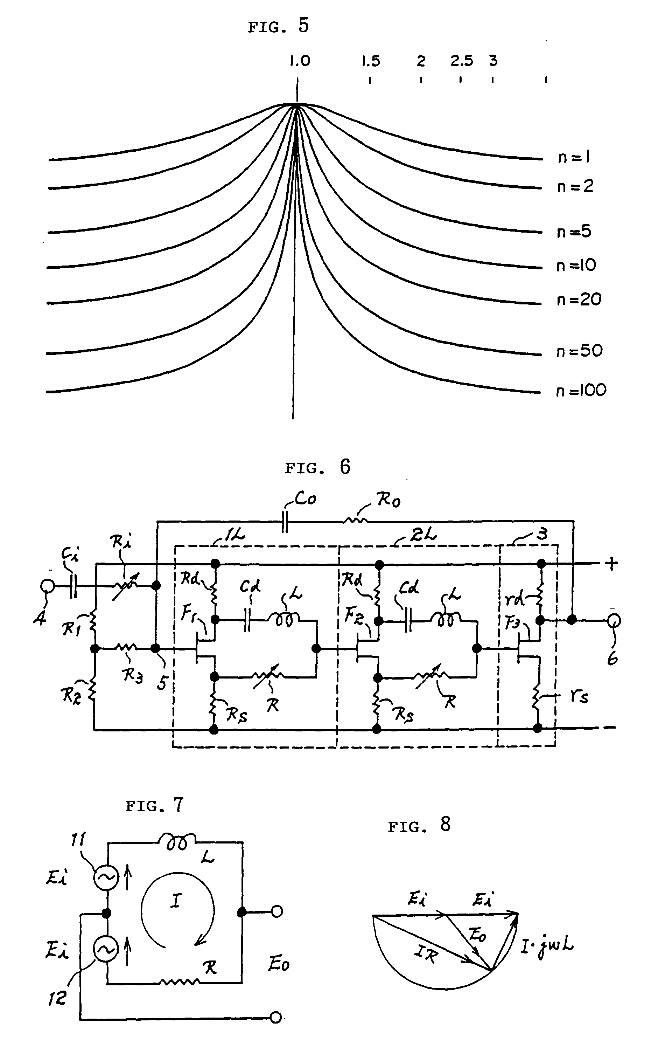

In the phase shift circuit as represented by such equivalent circuit, the output voltage Eo from the phase shift circuit comprises mutually orthogonal voltage components, a voltage component (IR) across the resistor R and a voltage component $(I/j\omega C)$ across the capacitor C and thus the absolute value of the output voltage Eo is equal to the radius of a circle and remains constant, equal to the input AC voltage Ei as illustrated in FIG. 4.

In order that the output voltage Eo and the input voltage Ei in the phase shift circuits 1C, 2C are orthogonal to each other, absolute values of the voltage component (IR) across the resistor R must be identical to that of the voltage component $(I/j\omega C)$ across the capacitor C. The condition $\omega CR=1$ is established when the output voltage Eo is rotated in phase by 90° with respect to the input voltage Ei.

A current I flowing through the closed loop in the equivalent circuit in FIG. 3 is given by the following expression (2)

$$I = \frac{2Ei}{R + (I/j\omega C)} \qquad (2)$$

Then, the output voltage Eo is given by the following expression (3)

$$Eo + IR - Ei = 0 \qquad (3)$$

The output voltage Eo can be given by the following expression (4) if you replace the expression (3) by the expression (3):

$$Eo = \frac{1 - j\omega CR}{1 + j\omega CR} \cdot Ei \qquad (4)$$

Then, the transfer function KI per stage of the phase shift circuit is given by the following expression (5):

$$K1 = \frac{EO}{Ej} = \frac{1-j\omega CR}{1+j\omega CR} \qquad (5)$$

The overall transfer function K using two stage of the phase of the phase shift circuits is given by the following expression (6):

$$K = \frac{(1-j\omega CR)^2}{(1+j\omega CR)^2} = \frac{(1-j\omega CR)^2 - 2j\omega CR+1}{(1+j\omega CR)^2 + 2j\omega CR+1} \qquad (6)$$

The transfer function K of the entire system including the phase inverter circuit 3 is given by the following expression (7):

$$K = \frac{(j\omega CR)^2 - 2j\omega CR+1}{(j\omega CR)^2 + 2j\omega CR+1} \qquad (7)$$

If you replace the expression (1) by the expression (7), then you will get the following expression (8):

$$A = -\frac{\frac{1}{2n+1} \cdot \{(1-\omega CR)^2 - 2j\omega CR\}}{1-(\omega CR)^2 + \frac{2j\omega CR}{2n+1}} \qquad (8)$$

You will understand from the above expression (8) that $A=-1/(2n+1)$ when $w=O(DC)$, thereby providing the maximum attenuation. It is also true with $\omega=\infty$. However, at the tuned frequency with $\omega CR=1$, $A=1$ which is unrelated to "n". In other words, not only the tuning point but also the attenuation at the tuning point remain unchanged regardless of "n" as illustrated in FIG. 5.

When the capacitor C is used as the reactance element like in the first embodiment, the time constant $T=CR$. Since both capacitor C and the resistor R can be increased easily, the circuit is particularly advantageous when operating in a lower frequency range.

As illustrated in FIG. 6, a second embodiment of the tuned amplifier comprises a cascade connection of a first phase shift circuit 1 L, a second phase shift circuit 2L and a phase inverter circuit 3. Further included are an input resistor Ri(=nRO) connected between the input terminal 4 and the summing point 5 and a feedback resistor Ro connected between the output terminal 6 of the phase inverter circuit 3 and the summing point 5.

The two phase shift circuits 1L, 2L are essentially identical in circuit configuration and comprise a FET (F1, F2). A resistor Rd connected between a positive voltage source and the drain electrode, a resistor Rs connected between a negative voltage source and the source electrode, an inductor L as a reactive element connected to the drain electrode, and a variable resistor R connected to the source electrode. The inductor L and the variable resistor R are commonly connected together at their output ends. It is to be noted here that a capacitor Cd connected in series with the inductor L is used for DC blocking purpose and has a very low impedance at the operating frequency. The resistors Rd and Rs connected respectively to the drain and source electrodes are designed to have essentially identical resistance.

In the second embodiment of the tuned amplifier, the phase shift circuits 1L, 2L can be represented by an equivalent circuit as shown in FIG. 7. The equivalent circuit is a closed loop comprising a signal source 11 generating an AC signal having the same polarity to the input AC signal Ei, a signal source 12 generating an AC signal having the opposite polarity to the input AC signal Ei, the inductor L and the resistor R.

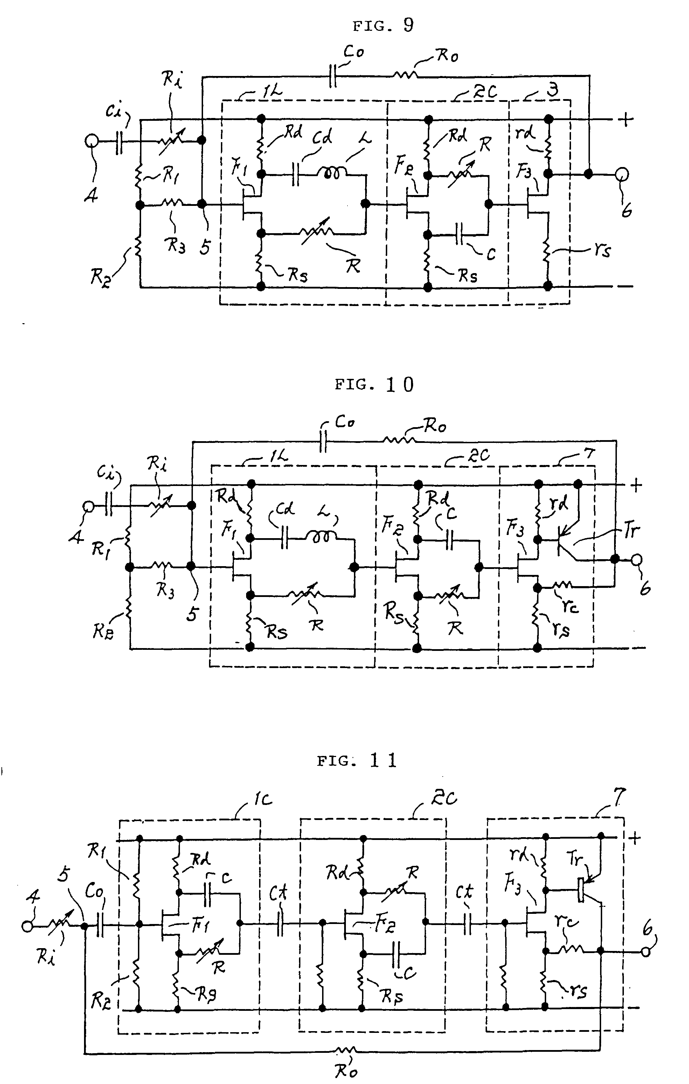

In the phase shift circuit as represented by the equivalent circuit, the output voltage Eo comprises mutually orthogonal two voltage components, a voltage (IR) across the resistor R and a voltage component (I.$j\omega L$) across the inductor L and has an absolute valve equal to the radius of a circle, i.e., a constant value equal to the input AC voltage Ei as illustrated by the circle diagram in FIG. 8.

As shown by the circle diagram in FIG.8, the voltage component (IR) across the resistor R and the voltage component (I.$j\omega L$) across the inductor L in the phase shift circuits 1 L, 2L are orthogonal with each other. The output voltage Eo is equal the radius of a circle or the input AC voltage Ei and remains unchanged.

The condition of making the output voltage Eo of the phase shift circuits 1L, 2L perpendicular to the input voltage Ei is that the voltage component (IR) across the resistor R is equal, to the voltage component (I.$j\omega L$) across the inductor L in absolute valve. The relationship $wL/R=I$ is established when the output voltage Eo is rotated by 90° with respect to the input voltage Ei.

The tuned amplifier will operate at a frequency that the two stages of the phase shift circuits 1L, 2L provide 180° phase shift and inversion by the phase inverter circuit 3 provides the remaining 180° phase shift for the total 360° phase shift.

The time constant T in the case of using the inductor L as a reactive element in the second embodiment is $T=L/R$. Since it is easy to reduce the inductance of the inductor L. This embodiment is useful in operating at a high frequency range.

As shown in FIG.9, a third embodiment of the tuned amplifier comprises a cascade connection of a first phase shift circuit 1 L, a second phase shift circuit 2C, and a phase inverter circuit 3. Further included are an input resistor Ri(=nRo) connected between an input terminal 4 and a summing point 5 and a feedback resistor Ro connected between an output terminal 6 of the phase inverter circuit 3 and the summing point 5.

The first phase shift circuit 1L comprises a FET (F1), a resistor Rd connected between a positive voltage source and the drain electrode, a resistor Rs connected between a negative voltage source and the source electrode, an inductor L as a reactive element having one end connected to the drain electrode, and a variable resistor R having one end connected to the source electrode. Output ends of the inductor L and the variable resistor R are coupled together. A capacitor C connected in series with the inductor L acts as DC blocking. The drain side resistor Rd and the source side resistor Rs are designed to have essentially identical resistance.

On the other hand, the second phase shift circuit 2C comprises a FET (F2), a resistor Rd connected between the positive voltage source and the drain electrode, a resistor Rs connected between the negative voltage source and the source electrode, a variable resistor R having one end connected to the drain electrode, and a capacitor C as a reactance element having one end connected to the source electrode. The output ends of the capacitor C and the variable resistor R are coupled together. The drain side resistor Rd and the source side resistor Rs are chosen to have essentially identical resistance.

It is to be noted here that in the third embodiment phase can be shifted in the same direction even if the inductor L in the first phase shift circuit 1L is connected to the same electrode of the FET (F1) and the capacitor C in the second phase shift circuit 2C connected to the source electrode of the FET (F2). Consequently, the two stages of the phase shift circuits 1 L and 2C will provide 180° phase shift in total and 360° phase shift is achieved by the phase inversion of the phase inverter circuit 3, thereby operating the tuned amplifier at a particular frequency to achieve the 360° phase shift.

In the third embodiment, as the frequency increases, the impedance of the inductor L in the first phase shift circuit 1L also increases, thereby increasing the output due to lighter load. However, the impedance of the capacitor C in the second phase shift circuit C decreases, thereby decreasing the output due to heavier load. This means that the tuned amplifier in the third embodiment is particularly suitable in operating at an intermediate frequency range because variations in outputs of the two phase shift circuits are cancelled out.

As shown in FIG. 10, a fourth embodiment comprises cascade connected first phase shift circuit 1L, second phase shift circuit 2C, non-inverting amplifier circuit 7 including a FET (F3) and a transistor Tr acting as a buffer circuit. Also included are an input resistor Ri (nRo) connected between the input terminal 4 and the summing point 5 and a feedback resistor Ro connected between the output terminal 6 of the non-inverting amplifier circuit 7 and the summing point 5.

The first phase shift circuit 1L comprises a FET (F1), a resistor Rd connected between the positive voltage source and the drain electrode, a resistor Rs connected between the negative voltage source and the source electrode, an inductor L connected to the drain electrode as a reactance element and a variable resistor R connected to the source electrode. The output sides of the inductor L and the variable resistor R are connected in common. A capacitor Cd connected in series with the inductor L is used as a DC blocking capacitor. The drain resistor Rd and the source resistor Rs are chosen to have essentially identical resistance.

On the other hand, the second phase shift circuit 2C comprises a resistor Rd connected between the positive voltage source and the drain electrode, a resistor Rs connected between the negative voltage source and the source electrode, a capacitor C connected to the drain electrode as a reactance element, and a variable resistor R connected to the source electrode. The output sides of the capacitor C and the variable resistor R are connected in common. Both of the drain resistor Rd and the source resistor Rs have essentially identical resistance.

In the fourth embodiment, connection of inductor L to the drain electrode of the FET (F1) in the first phase shift circuit 1 L and connection of capacitor C to the drain electrode of the FET (F2) in the second phase shift circuit 2C will shift the phase to the opposite direction by the inductor L and the capacitor C, thereby causing 0° phase shift by summing the phase shifts of the two phase shift circuits 1 L, 2C. If the non-inverting output of the non-inverting amplifier 7 is positively fed back to the summing point 5 through the feedback resistor Ro, a tuned amplifying operation will be achieved.

It is to be understood that the non-inverting amplifier circuit 7 operating as a buffer circuit comprises a FET (F3), a resistor rd connected between the positive voltage source and the drain electrode, a resistor rs connected between the negative voltage source and the source electrode, and a PNP transistor Tr having the base electrode connected to the drain electrode of the FET (F3). The emitter of the transistor Tr is directly connected to the positive voltage source and the collector electrode connected to the source electrode of the FET (F3) by way of a resistor rc. The amplification factor (gain) of the non-inverting amplifier circuit 7 varies depending on the adjustment of the resistor rc.

Shown in FIG.11 is a fifth embodiment of the tuned amplifier comprising a cascade connection of a first phase shift circuit 1C, a second phase shift circuit 2C and a non-inverting amplifier circuit 7 operating as a buffer circuit. Also included are an input resistor Ri (=nRo) connected between the input terminal 4 and the summing point 5, and a feedback resistor Ro connected between the output terminal 6 of the non-inverting amplifier circuit 7 and the summing point 5.

The first phase shift circuit 1C comprises a FET (F1), a resistor Rd connected between the positive power supply and the drain electrode, a resistor Rs connected between the negative voltage source and the source electrode, a capacitor C as a reactance element having one end connected to the drain electrode, and a variable resistor having one end connected to the source electrode. Other ends of the capacitor C and the variable resistor R are connected together in common.

The second phase shift circuit 2C comprises a FET (F2), a resistor Rd connected between the positive voltage source and the drain electrode, a resistor Rs connected between the negative voltage source and the source electrode, a variable resistor R connected to the drain electrode, and a capacitor C connected to the source electrode as a reactance element. Output ends of the variable resistor R and the capacitor C are coupled together.

It is to be noted that the drain resistors Rd and the source resistors Rs in the two phase shift circuits 1C and 2C have substantially identical resistance to each other.

The summing point 5 in the first phase shift circuit 1C is connected to the input terminal 4 through a controllable input resistor Ri and also to the output terminal 6 of the non-inverting amplifier circuit through the feedback resistor Ro.

Additionally, applied to the gate electrode of the FET (F1) is a bias voltage which is derived from the power sully voltage by way of voltage dividing resistors R1, R2. The gate electrode of the FET (F1) is connected to the summing point 5 by way of a DC blocking capacitor Co. Note that the capacitor Co may be eliminated in order to amplify low frequency signals.

In this particular embodiment, the capacitor C in the first phase shift circuit 1C is connected to the drain electrode of the FET (F1) and the capacitor C in the second phase shift circuit 2C is connected to the source electrode of the FET (F2), thereby shifting the phase in the two phase shift circuits 1C, 2C in the opposite directions. The net phase shift of the two phase shift circuits 1C, 2C is 0° so that a positive feedback from the non-inverting amplifier circuit 7 to the summing point 5 through the feedback resistor Ro will cause a tuned amplifying operation.

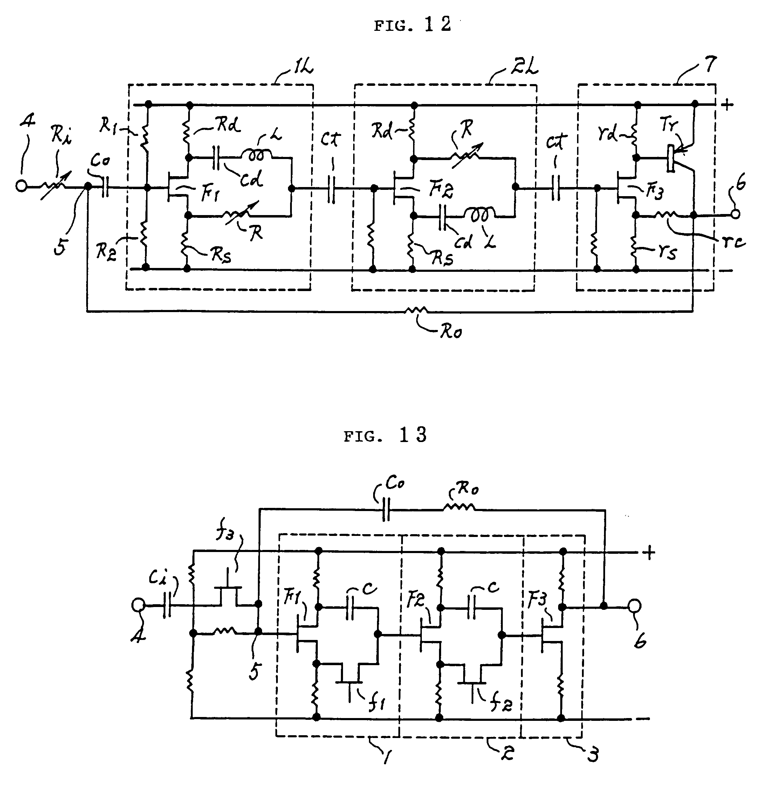

Although the capacitors C are used as reactance elements in the phase shift circuits 1C, 2C in the fifth embodiment as shown in a in FIG. 11, inductors L are used as reactance elements in a sixth embodiment as shown in FIG. 12.

A first phase shift circuit 1 L comprises a FET (F1), a resistor Rd connected between the positive voltage source and the drain electrode, a resistor Rs connected between the negative voltage source and the source electrode, an inductor L connected to the drain electrode as a reactance element, and a variable resistor R connected to the source electrode. Output ends of the inductor L and the variable resistor R are connected together in common.

On the other hand, a second phase shift circuit 2L comprises a FET (F2), a resistor Rd connected between the positive voltage source and the drain electrode, a resistor Rs connected between the negative voltage source and the source electrode, a variable resistor R connected to the- drain electrode, and an inductor L connected to the source electrode as a reactance element. Output ends of the inductor L and the variable R are connected in common.

In each phase shift circuit 1L, 2L, a capacitor Cd connected in series with the inductor L is used to block DC current and has a very low impedance at the - operation frequency. The drain resistor Rd and the source resistor Rs are chosen to have essentially identical resistance to each other.

In this particular embodiment, connection of the inductor L in the first phase shift circuit 1L to the drain side of the FET (F1) and the inductor L in the second phase shift circuit 2L to the source side of the FET (F2) will shift the phase in the two phase shift circuit 1 L, 2L in the opposite directions to provide net 0° phase shift by the two stage phase shift circuits 1 L, 2L. This causes a positive feedback to the summing point 5 from the non-inverting amplifier circuit 7 through the feedback resistor Ro, thereby achieving a tuned amplifier operation.

In the aforementioned embodiments to practice the present invention, FETs are used in the phase shift circuits. However, it is to be noted that bipolar transistors may be used to achieve the same result.

Also, for the resistor R in each of first and second phase shift circuits 1, 2, a channel resistance between source and drain electrodes of an FET (f1, f2) may be used so that the channel resistance can be varied by externally controlling the gate voltage of such FET (f1, f2) as shown in FIG. 13. In this manner, the amount of Phase shift of each phase shift circuit may be adjusted to control the tuned frequency. It is to be noted, here, that the resistance of the resistor R in either one of the two stage phase shift circuits can be varied easily to provide fine adjustment of the tuned frequency.

Similarly, the input resistance Ri(=nRo) may also be replaced by the channel resistance of a FET (f3). When the gate voltage of the FET (f3) is externally varied to change its resistance, the "n" in the above expression (8) is varied, thereby adjusting the maximum amount of attenuation as shown in FIG. 5.

In a case of using multiple stages of ideal phase shift circuits each having a constant output voltage, the output voltage remains unchanged even if the circuit parameter R is changed in a single stage or both stages. This is effective in integrating the entire circuits of the tuned amplifier in a single chip.

Also, in a case of using a capacitor as a reactance element in each phase shift circuit, the capacitor may be formed by way of an insulating oxide film such as $SiO_2$. In case of using an inductor as a reactance element in each of the phase shift circuit, an inductor may be formed using a spiral coil made by conventional photo light graphic manner.

The time constant T is equal to CR and L/R when a capacitor and an inductor are used as a reactance element, respectively.

It is therefore advantageous to use a capacitor when operating at lower frequencies but better to use an inductor at higher frequencies.

As understood from the above, each element constituting the tuned amplifier according to the present invention may be made by using conventional IC fabrication steps, and the tuned amplifier according to the present invention may be made in quantity at lower cost as an integrated circuit on a semiconductor wafer.

As fully understood from the above description in the best modes to implement the present invention, the tuned amplifier according to the present invention is capable of adjusting the tuned frequency and the maximum attenuation to any desired value without interaction, thereby providing an amplifier best fit to desired frequency and waveform of the signal to be amplified. Additionally, each element of the tuned amplifier may be made by conventional IC fabrication processes, thereby allowing the tuned amplifier to be made in a miniature form on a semiconductor wafer as integrated circuit. This is particularly suited for a quantity production at a lower cost.

Especially, It the channel resistance between the drain and source electrodes of an FET is used as a variable resistance in each phaseshift circuit for externally controlling the channel resistance by applying a control voltage to the gate electrode of the FET, it is possible to avoid adverse effects of the inductance and capacitance of the wiring to apply the control voltage, thereby providing the tuned amplifier with an ideal characteristic depending on the design.

Additionally, in a resonance circuit comprising capacitor C and inductor L, the resonance frequency $f_o$ is equal to:

$$f_o = 1/2 \pi \sqrt{LC}$$

If the capacitor C or the inductor L is varied to adjust the resonance frequency, the frequency changes in proportion to the root of the varied capacitor C or inductor L. In the tuned amplifier according to the present invention, however, the tuned frequency varies in proportion to the resistance, thereby enabling to vary the frequency over a wide range.

**Claims**

1. A tuned amplifier comprising:-

    a first phase shift circuit (1C, 1L) comprising conversion means (F1) to convert an AC input signal applied through an input impedance (Pi) into non-inverted and inverted AC signals and means comprising a first reactance element (C, L) and a first resistor (R) for combining the two AC signals converted by the conversion means (F1) of the first phase shift circuit (1C, 1L) to produce a first phase shifted AC output signal, a second phase shift circuit (2C, 2L) comprising conversion means (F2) to convert the first phase shifted AC output signal into non-inverted and inverted AC signals and means comprising a second reactance element (C, L) and a second resistor (R) for combining the two AC signals converted by the conversion means (F2) of the second phase shift circuit (2C, 2L) to produce a second phase shifted AC output signal which is phase shifted in the same direction as the first phase shifted AC output signal, an inverter circuit (3) for inverting the phase of the second phase shifted AC output signal, and a feedback circuit connected between the output (6) of the inverter circuit (3) and the input of the first phase shift circuit (1C, 1L) and having a feedback impedance (Ro, Co).

2. A tuned amplifier comprising

    a first phase shift circuit (1C, 1L) comprising conversion means (F1) to convert an input AC signal applied through an input impedance (Ri) into non-inverted and inverted AC signals and means for combining the two converted AC signals by way of a first reactance element (C, L) and a first resistor (R) to produce a first phase shifted AC output signal, a second phase shift circuit (2C, 2L) comprising conversion means (F2) to convert the first phase shifted AC output signal into non-inverted and inverted AC signals and means for combining the two AC signals converted by the conversion means (F2) of the second phase shift circuit (2C, 2L) by way of a second reactance element (C, L) and a second resistor (R) to produce a second phase shifted AC output signal which is phase shifted in the opposite direction to that of said first phase shifted AC output signal, and a feedback circuit for feeding the second phase shifted AC output signal back to the input of the first phase shift circuit (1C, 1L) by way of a feedback impedance (Co, Ro).

3. A tuned amplifier as claimed in claim 2, wherein a non-inverting amplifier (7) is interposed between the output of said second phase shift circuit (2C, 2L) and the feedback impedance (Co, Ro).

4. A tuned amplifier as claimed in claim 1, 2 or 3, wherein the first resistor (R) of the first phase shift circuit (1C, 1L) and/or the second resistor (R) of the second phase shift circuit (2C, 2L) are/is adjustable to control the tuned frequency.

5. A tuned amplifier as claimed in claim 1, 2, 3 or 4, wherein the ratio of the resistance (Ri) of the input impedance and the resistance (Ro) of the feed back impedance is adjustable to control the maximum attenuation.

6. A tuned amplifier as claimed in any preceding claim, wherein the channel resistance (fl, f2) of an FET is used as each of the resistors.

7. A tuned amplifier as claimed in any preceding claim, wherein the amplifier circuit is implemented as an integrated circuit.

**Patentansprüche**

1. Resonanzverstärker, der aufweist:

eine erste Phasenschieberschaltung (1C, 1L) aufweisend eine Konversionseinrichtung (F1), um ein AC-Eingangssignal, das über eine Eingangsimpedanz (Pi) angelegt wird, in ein nicht invertiertes und invertiertes AC-Signal zu konvertieren, und eine Einrichtung, die ein erstes Blindwiderstandselement (C, L) und einen ersten Widerstand (R) aufweist, um die zwei AC-Signale zu kombinieren, die durch die Konversionseinrichtung (F1) der ersten Phasenschieberschaltung (1C, 1L) konvertiert werden, um ein erstes phasenverschobenes AC-Ausgangssignal zu erzeugen,
eine zweite Phasenschieberschaltung (2C, 2L), aufweisend eine Konversionseinrichtung (F2), um das erste phasenverschobene AC-Ausgangssignal in ein nicht invertiertes und ein invertiertes AC-Signal zu konvertieren, und eine Einrichtung, die ein zweites Blindwiderstandselement (C, L) und einen zweiten Widerstand (R) aufweist, um die zwei AC-Signale zu kombinieren, die durch die Konversionseinrichtung (F2) der zweiten Phasenschieberschaltung (2C, 2L) konvertiert werden, um ein zweites phasenverschobenes AC-Ausgangssignal zu erzeugen, das in die gleiche Richtung wie das erste phasenverschobene AC-Ausgangssignal phasenverschoben ist,
eine Inverterschaltung (3) zum Invertieren der Phase des zweiten phasenverschobenen AC-Ausgangssignals, und
eine Rückkopplungsschaltung, die zwischen dem Ausgang (6) der Inverterschaltung (3) und dem Eingang der ersten Phasenschieberschaltung (1C, 1L) verbunden ist und eine Rückkopplungsimpedanz (Ro, Co) aufweist.

2. Resonanzverstärker, der aufweist

eine erste Phasenschieberschaltung (1C, 1L), aufweisend eine Konversionseinrichtung (F1), um ein Eingangs-AC-Signal, das über eine Eingabeimpedanz (Ri) angelegt wird, in ein nicht invertierendes und ein invertierendes AC-Signal zu konvertieren, und eine Einrichtung zum Kombinieren der zwei konvertierten AC-Signale durch ein erstes Blindwiderstandelement (C, L) und einen ersten Widerstand (R), um ein erstes phasenverschobenes AC-Ausgangssignal zu erzeugen,
eine zweite Phasenschieberschaltung (2C, 2L), aufweisend eine Konversionseinrichtung (F2), um das erste phasenverschobene AC-Ausgangssignal in ein nicht invertiertes und ein invertiertes AC-Signal zu konvertieren, und eine Einrichtung zum Kombinieren der zwei AC-Signale, die durch die Konversionseinrichtung (F2) der zweiten Phasenschieberschaltung (2C, 2L) durch ein zweites Blindwiderstandelement (C, L) und einen zweiten Widerstand (R) konvertiert werden, um ein zweites phasenverschobenes AC-Ausgangssignal zu erzeugen, das gegenüber dem ersten phasenverschobenen AC-Ausgangssignal in entgegengesetzter Richtung phasenverschoben ist, und
eine Rückkopplungsschaltung, um das zweite phasenverschobene AC-Ausgangssignal an den Eingang der ersten Phasenschieberschaltung (1C, 1L) über eine Rückkopplungsimpedanz (CoRo) zurückzukoppeln.

3. Resonanzverstärker gemäß Anspruch 2, wobei sich ein nicht invertierender Verstärker (7) zwischen dem Ausgang der zweiten Phasenschieberschaltung (2C, 2L) und der Rückkopplungsimpedanz (Co, Ro) befindet.

4. Resonanzverstärker gemäß einem der Ansprüche 1, 2 oder 3, wobei der erste Widerstand (R) der ersten Phasenschieberschaltung (1C, 1L) und/oder der zweiten Phasenschieberschaltung (2C, 2L) einstellbar ist/sind, um die abgestimmte Frequenz zu steuern.

5. Resonanzverstärker gemäß Anspruch 1, 2, 3 oder 4, wobei der Quotient aus dem Widerstand (Ri) der Eingangsimpedanz und dem Widerstand (Ro) der Rückkopplungsimpedanz einstellbar ist, um die maximale Dämpfung zu steuern.

6. Resonanzverstärker gemäß einem der vorhergehenden Ansprüche, wobei der Kanalwiderstand (f1, f2) eines FET jeweils als einer der Widerstände benutzt wird.

7. Resonanzverstärker gemäß einem der vorhergehenden Ansprüche, wobei die Verstärkerschaltung als eine integrierte Schaltung implementiert ist.

**Revendications**

1. Amplificateur accordé comprenant :

   un premier circuit de décalage de phase (C, L) comprenant des moyens de conversion (F1) pour convertir un signal d'entrée de courant alternatif appliqué à travers une impédance d'entrée (Pi) en des signaux de courant alternatif non-inversé et inversé et des moyens comprenant un premier élément de réactance (C, L) et une première résistance (R) pour combiner les deux signaux de courant alternatif convertis par les moyens de conversion (F1) du premier circuit de décalage de phase (1C, 1L) pour produire un premier signal de sortie de courant alternatif décalé en phase,
   un second circuit de décalage (2C, 2L) comprenant des moyens de conversion (F2) pour convertir le premier signal de sortie de courant alternatif décalé en phase en des signaux de courant alternatif non-inversé et inversé et des moyens comprenant un second élément de réactance (C, L) et une seconde résistance (R) pour combiner les deux signaux de courant alternatif convertis par les moyens de conversion (F2) du second circuit de décalage de phase (2C, 2L) pour produire un second signal de sortie de courant alternatif décalé en phase qui est décalé en phase dans la même direction que le premier signal de sortie de courant alternatif décalé' en phase,
   un circuit inverseur (3) pour inverser la phase du second signal de sortie de courant alternatif décalé en phase et,
   un circuit de rétroaction connecté entre la sortie (6) du circuit inverseur (3) et l'entrée du premier circuit de décalage de phase (1C, 1L) et présentant une impédance de rétroaction (Ro, Co).

2. Amplificateur accordé comprenant :

   un premier circuit de décalage de phase (1C, 1L) comprenant des moyens de conversion (F1) pour convertir un signal de courant alternatif d'entrée appliqué à travers une impédance d'entrée (Ri) en des signaux de courant alternatif non-inversé et inversé et des moyens pour combiner les deux signaux de courant alternatif convertis au moyen d'un premier élément de réactance (C, L) et une première résistance (R) pour produire un premier signal de sortie de courant alternatif décalé en phase,
   un second circuit de décalage de phase (2C, 2L) comprenant des moyens de conversion (F2) pour convertir le premier signal de sortie de courant alternatif décalé en phase en des signaux de courant alternatif non-inversé et inversé et des moyens pour combiner les deux signaux de courant alternatif convertis par les moyens de conversion (F2) du second circuit de décalage de phase (2C, 2L) au moyen d'un second élément de réactance (C, L) et une seconde résistance (R) pour produire un second signal de sortie de courant alternatif décalé en phase qui est décalé en phase dans la direction opposée à celle du premier signal de sortie de courant alternatif décalé en phase, et
   un circuit de rétroaction pour ramener le second signal de sortie de courant alternatif décalé en phase sur l'entrée du premier circuit de décalage de phase (1C, 1L) au moyen d'une impédance de rétroaction (Co, Ro).

3. Amplificateur accordé selon la revendication 2, dans lequel un amplificateur non-inverseur (7) est inséré entre la sortie dudit second circuit de décalage de phase (2C, 2L) et l'impédance de rétroaction (Co, Ro).

4. Amplificateur accordé selon l'une des revendications 1 à 3, dans lequel la première résistance (R) du premier circuit de décalage de phase (1C, 1L) et/ou la seconde résistance (R) du second circuit de décalage de phase (2C, 2L) sont/est ajustable (s) pour commander la fréquence d'accord.

5. Amplificateur accordé selon l'une des revendications 1 à 4, dans lequel le rapport entre la résistance (Ri) de l'impédance d'entrée et la résistance (Ro) de l'impédance de rétroaction est ajustable pour commander l'atténuation maximale.

6. Amplificateur accordé selon l'une quelconque des revendications précédentes, dans lequel la résistance de canal (f1, f2) d'un transistor à effet de champ est utilisée pour chacune des résistances.

7. Amplificateur accordé selon l'une quelconque des revendications précédentes, dans lequel le circuit amplificateur est réalisé en circuit intégré.

FIG. 1

FIG. 2

(a)

(b)

FIG. 3

FIG. 4

FIG. 5

FIG. 6

FIG. 7

FIG. 8

FIG. 9

FIG. 10

FIG. 11

12

FIG. 12

FIG. 13